# EUROPEAN PATENT APPLICATION

(11) **EP 4 164 191 A1**
(43) Date of publication of application: **12.04.2023**
(21) Application number: 21306416.5
(22) Date of filing: 08.10.2021
(51) Int. Cl.: H04L 41/0806

(54) **CODING CIRCUIT, DECODING CIRCUIT, VOLTAGE INFORMATION SYSTEM**

(71) Applicant: Schneider Electric Industries SAS, 92500 Rueil-Malmaison (FR)
(72) Inventor: Krápek, Pavel, 68725 Hluk (CZ); Dohnal, Mirolsav, 76325 Ujezd u Valasskych Klobouk (CZ)
(74) Representative: Manitz Finsterwald Patent- und Rechtsanwaltspartnerschaft mbB

(57) **Abstract**

A coding circuit (10) for coding an AC voltage amplitude comprises a rectifying circuit (11) configured to output a pulsating DC voltage (U5) and signalling means (12) for outputting a signal representing a timing value of said pulsating DC voltage.

## Description

The invention is a coding circuit, a decoding circuit and a voltage information system.

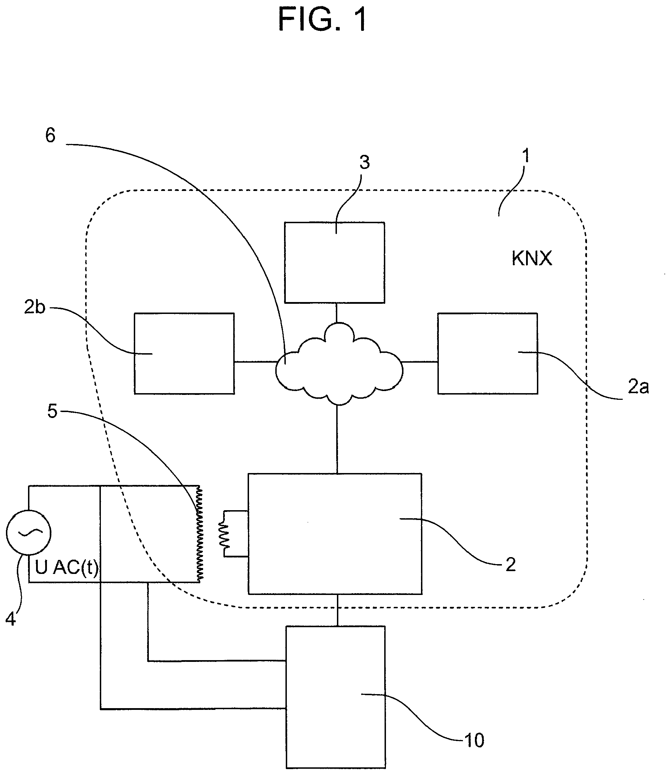

Although Fig. 1 shows already features of the invention, it also shows the known environment within which the invention is intended to operate.

In Fig. 1, boxes 2, 2a, 2b represent electrical consumers of various types. They may be lighting, computers, controllers, electrical motors for various purposes, and the like. The consumers have power supplies. They may be of different type. They may have a variety of power supplies. One power supply 4 is shown for a consumer 2.

In modern electrical environments, the consumers are managed by a central managing device 3. The consumers 2, 2a, 2b are connected to the management device 3 by appropriate interconnections or network means 6. It may be a wired network or a wireless network. The interconnections or network may be standard interconnections or network such as the internet. It may use standardized hardware such as the IP protocol, Wi-Fi and the like for a network.

Another example for an electrical environment using interconnections of consumers to a central controller is the KNX environment or the EIB environment. In a narrower sense, KNX or EIB designate a bus for connecting components used in building automation. In a broader sense, it designates the entire infrastructure connected by said bus systems.

The central controller 3 needs to have information on the various consumers 2 integrated into the mentioned environment. The information includes nature and particular types of the respective consumers, other information pieces, and includes also information on their power supply. This information is input to the controller 3 when installing the consumer 2 into the system. To a significant extent, these entries are made manually. Particularly, information on power supply of consumers 2 is often entered manually, particularly when it is not a standard supply such as the standard 230 volts used in Europe or 110 volts used in USA, Japan and the like. Manual input is prone to errors, and thus there is a desire to find automatic structures for forwarding power supply information.

The problem is aggravated by the fact that in many cases the consumer 2 does not "see" its primary power supply because it sits behind circuitry or a galvanic isolation which may be an inverter or a transformer for shaping a source voltage into an input voltage of the consumer. The consumer itself then sees its input supply, but does not "know" what the real voltage of the power source is.

It is the object of the invention to provide a coding circuit, a decoding circuit and a voltage information system capable of rendering automated supply voltage information, or contributing at least thereto.

This object is accomplished by the features of the independent claims.

A coding circuit for coding an AC voltage amplitude comprises inputs to receive said AC voltage, a rectifying circuit configured to output a pulsating DC voltage and signaling means for generating and outputting a signal representing a timing value of said pulsating DC value.

In a very general sense, the invented circuit converts a timing value of an AC or a pulsating DC voltage into an output signal transporting said timing value for use elsewhere. The timing value may be an absolute or relative value of a time for which the pulsating DC is above a threshold or below a threshold or at a value or value range, the threshold or value or value range including zero, wherein zero may here include voltages up to ±2 or ±1 volts and induced AC for including induced or circuit noise in the definition of zero.

It is further pointed out that it is also conceivable to render the mentioned timing value conversion without a rectifying circuit by observing and evaluating time spans above zero level.

The mentioned output signal may be a pulse correlating in its frequency to that of the input AC, i.e. may be a sequence of impulses, and the length of the individual impulses may unambiguously correlate with the AC voltage amplitude from which said pulse was generated. It is pointed out that the correlation may be nonlinear.

The impulses of the output signal may have an amplitude suitable for further downstream processing. The amplitude may be suitable for driving digital components, such as gates, or for driving an opto-coupler. The voltage level of the impulses of the generated pulse may be meaningless for the information to be transported, i.e. the AC voltage amplitude.

Each of the impulses of the generated pulse may carry the information on the AC voltage amplitude from which they were generated and can be sent out as such. On a receiving side, they run into a decoding circuit that decodes the desired information from the received pulse, i.e. from the individual impulses of the pulse so that after decoding the information on the AC voltage amplitude is present on the decoding side. It can then be further used and/or transmitted and/or stored and/or entered for administrative purposes or the like.

Together, the coding circuit and the decoding circuit constitute a voltage information system capable of communicating AC voltage amplitude information elsewhere, for example across the system boundaries, particularly, for example, galvanic separation or circuit separations or logic separation, so that also "behind" such a separation and possibly at a remote location it is known which kind of power supply is given upstream.

When a rectifying circuit is used, which is not necessarily the case, it may comprise one or more diodes. It may be one diode for a half wave rectifier or may be a full wave rectifier comprising the well-known four diodes of two parallel series connections of respectively two diodes.

Generally speaking, the coding circuit may have threshold rendering means for rendering a forward threshold voltage for the examined AC. The threshold may, for example, be at least the forward threshold voltage of the diodes that may be used for the rectifier. Additional dedicated threshold rendering means may be provided.

Providing the forward threshold has the effect that for a longer or shorter time the rectified signal is zero, namely for the time within which the instantaneous value is below the respective threshold. Besides, this time depends on the amplitude of the coded AC because the higher the AC amplitude is, the earlier the instantaneous AC value surpasses the threshold and the later it drops below it. Then, zero monitoring can be made for having the zero duration, also called "off-time" in this specification, as an indirect measure for the amplitude of the considered AC.

When the rectifier is a full wave diode rectifier, it may comprise threshold rendering means for rendering a first forward threshold voltage for the one half wave and for rendering a second forward threshold voltage for the other half wave. The first and the second forward threshold voltages may be the same or may be different. For example, the first may be somewhere between 4 and 12 volts, the other may be somewhere between 30 and 50 volts.

This means that the two different qualities of half waves surmount their respective forward thresholds at different relative timings within each full AC wave. Assuming that the one threshold is 10 volts and the other is 40 volts, at an AC amplitude of e.g. 8 volts, no half wave would pass any threshold. If, however, the amplitude is between 10 and 40 volts and, e.g., at 25 volts, at least the one half wave passes the 10 volts threshold. And if the amplitude is above 40 volts, both half waves will pass their respective threshold. This all again influences the already mentioned zero time or off-time which is an indirect measure for the amplitude of the considered AC.

For rendering the mentioned different thresholds for the different half waves, an asymmetric circuit element or asymmetric circuit portion can be used on the AC side. It may be asymmetric in its pass characteristics with respect to zero. A Zener diode is such circuit element. The circuit may comprise one or a series connection of two or more such Zener diodes for rendering the mentioned asymmetric forward thresholds.

On the DC side of the rectifier, another threshold rendering means may be provided, which then would act symmetrically on both halfwaves. It may again be a Zener diode or a transistor of a current limiter that contributes to providing the desired forward threshold by having a certain drain-source-voltage.

The signaling means may comprise a pulse generator generating a pulse signal in accordance with said pulsating DC voltage. As explained above, the pulsating DC voltage is influenced by the potentially provided forward threshold voltages, and accordingly also the timing values are influenced. The signaling means may generate impulses per half wave or per full wave. The duration of the generated impulses may directly correspond to the off-time of the pulsating DC voltage or may correspond to an on-time. The amplitude of the generated impulses may be set suitable for further processing as desired. For rendering a desired impulse amplitude, a current limiter may be provided for bringing the potentially high pulsating DC voltage down to required levels.

The pulse signal may be suited for driving an opto-coupler that is provided beyond the coding circuit. But likewise, the coding circuit itself may have, at its output, an opto-coupler driven by the generated pulse signal. Then, the output of the opto-coupler is the coding circuit output, and the output signal may then possibly be a variable resistance between two output terminals of the opto-coupler, or may be a voltage signal or some other kind of well defined signal.

Once a pulse signal with impulses carrying the AC voltage amplitude information is generated, said signal may be further processed. This further processing may happen in the coding circuit or in a separate decoding circuit. The further processing may comprise the measurement of the impulse duration of the generated impulses, as they carry the information on the amplitude of the considered AC voltage.

As an example, it is assumed here that the impulses correspond to the off-time of the mentioned pulsating DC voltage. Their duration can be measured, for example, by counting with suitably high frequency. If, for example, counting is made with a frequency of 20 kHz, this would give, at 50 Hz power supply frequency, 200 count values per half wave and would thus be a fine enough resolution for probing the respective impulses.

As mentioned earlier, the impulses duration will most likely be nonlinear over the AC voltage amplitude they represent. Thus, conversion means may be provided for converting the measured impulses duration into corresponding voltage amplitude values. This conversion uses a predefined characteristics. It requires means for applying this characteristics onto the measured. It may, for example, be a table in a digital device with pairs of impulse duration and corresponding AC amplitude as respective pairs of input and output. This conversion may be made on the digital side of, for example, a controller.

The timing values used for accessing the table may be kind of absolute values, possibly representing real time values, such as, for example, 3,2 msec. But instead of using real time values, other scaling can be used, as long as it is known. Further, the value may be absolute as explained above, or may be relative. It may be referenced to the period duration of the considered AC, which is, in the case of 50 Hz, 20 msec, or in the case of 60 Hz, 16,67 msec. Or it may be referenced to a count value corresponding to 20 msec. The timing values may then be percent indications, such as 38%, meaning for example that off-time was 38% of the full wave. They may also be referenced to half wave durations, if for some reasons more convenient.

Providing different thresholds for the two different half waves has the effect that measurement resolution is better spread across the available range. The thresholds can be chosen in view of such a desired resolution distribution. The lower of the two thresholds may, for example, be lower than 40 or 30 or 20 volts and may be higher than 4 or 6 or 8 volts and may be around 10 volts, whereas the higher of them may be higher than 20 or 30 or 40 volts and may be lower than 100 or 70 or 50 volts. Then, a resolution is relatively fine at voltage amplitude values above the respective threshold values.

Preferably, a current limiter is provided on the AC or DC side for limiting the output of the coding circuit to values that can be handled by the subsequent devices, such as opto-couplers or digital gates or circuits. The current limiter may be seen as a nonlinear resistor actively driven with some internal feedback and possibly current sensing. It may comprise a transistor. The transistor itself may have a forward threshold voltage. As far it is located on the DC side, said threshold will apply for both half waves. It would add up to the individual thresholds provided for the half waves on the AC side, if any.

Thus, looking at threshold rendering means, they may comprise diodes of diode rectification, asymmetric circuit parts on the AC side, for example the mentioned Zener diode, and possibly further forward threshold rendering means on the DC side, such as the mentioned transistor of a current limiter.

As said above, the mentioned evaluation of measuring pulse duration and assigning AC amplitude voltage values to said durations may be part of the mentioned coding circuit. But likewise, the coding circuit may, for example, "end" with the impulse generator or possibly with the opto-coupler. The other described components may be seen as parts of a decoding circuit that receive the pulse signal and assign, in the mentioned manner, AC voltage amplitude values to them. Thereafter, the obtained value may be stored or transmitted to a remote destination or internally be used as required.

A coding circuit and a decoding circuit in combination may be seen as a voltage information system.

The coding circuit may be a stand-alone circuit connected to the AC source. It has an output for the generated pulse.

The decoding circuit may be part of a consumer receiving the evaluated AC as its power supply and may have an input complementing in its layout the output of the coding circuit. The decoding circuit may then be configured to add to the determined AC voltage amplitude value an identification information for identifying the consumer from which the determined voltage value comes. Again, this may happen on the digital side of a controller. But likewise, the determined AC voltage amplitude information may directly go to a controller for appropriate use.

In the following, embodiments of the invention will be described with reference to the drawings, in which
- Fig. 1: is the schematic representation of an environment within which the described circuit is provided,
- Fig. 2a: is a block diagram of the coding circuit,
- Fig. 2b: shows elementary considerations regarding the measurement principle,
- Fig. 3a-c: shows a rectifier and waveforms,
- Fig. 4, b: shows a voltage limiter and a waveform,
- Fig. 5: shows a real coding circuit,
- Fig. 6: shows waveforms in the circuit of fig. 5 as an embodiment with asymmetric thresholds,
- Fig. 7: shows an overall characteristics,
- Fig. 8: shows a possible decoding circuit in the environment, and
- Fig. 9: shows a more detailed block diagram of the decoding circuit.

In Fig. 1, it is assumed that consumers 2, 2a and 2b are part of a controlled KNX environment 1 having a controller 3. Interconnection of the consumers 2 and controller 3 may be made through appropriate connections and/or protocols. The connections may be wired connections or wireless connections. The connection lines may be dedicated information lines or may be lines provided anyway, for example power supply lines, on which information to be exchanged is superimposed. The connection mechanism is symbolized by numeral 6. It may be or comprise a switched network or a bus system or individual lines or the like. The environment 1 may be a KNX environment or an EIB environment.

4 is an AC power source feeding consumer 2. It is assumed that controller 3 does not know from beginning on what kind of power supply numeral 4 is. For overcoming this, coding circuit 10 is provided, at least. As shown in Fig. 1, coding circuit 10 taps off the AC power from source 4 and further processes it and outputs a signal to the consumer 2 fed by power source 4. But instead of feeding the signal to consumer 2 fed by power source 4, the signal generated by circuit 10 may be fed elsewhere, for example directly to controller 3. Possibly, consumer 2 is galvanically insulated from power source 4 by a transformer 5, or receives power from an inverter or chopper or the like. Then, consumer 2 does not really know what kind of voltage power source 4 provides because consumer 2 sees only the voltage at its input terminals, such as the secondary voltage of transformer 5. Voltage source 4 produces an AC voltage U_{AC}(t).

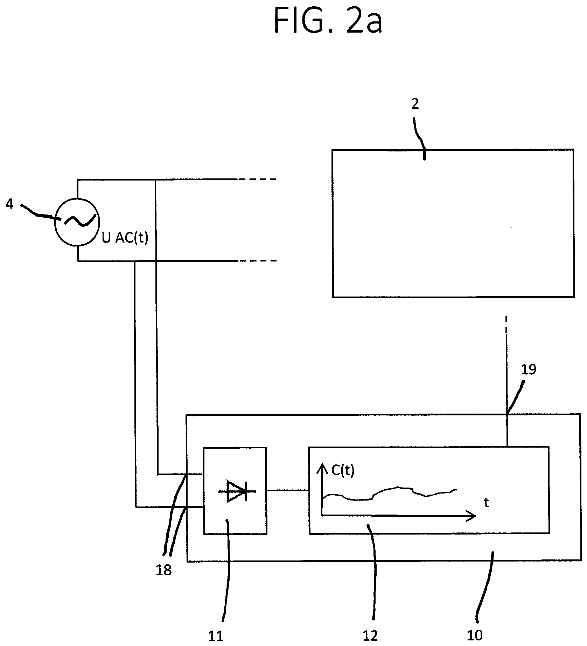

Coding circuit 10 receives said supply voltage U_{AC}(t) and processes it. Fig. 2a shows a more detailed block circuit diagram of the coding circuit 10. It receives the power supply voltage U_{AC}(t) from power source 4 at terminals 18. It then may have a rectifier 11 that produces a pulsating DC voltage. It may be a half wave rectifier with a single diode or a full wave rectifier with two parallel diode bridges.

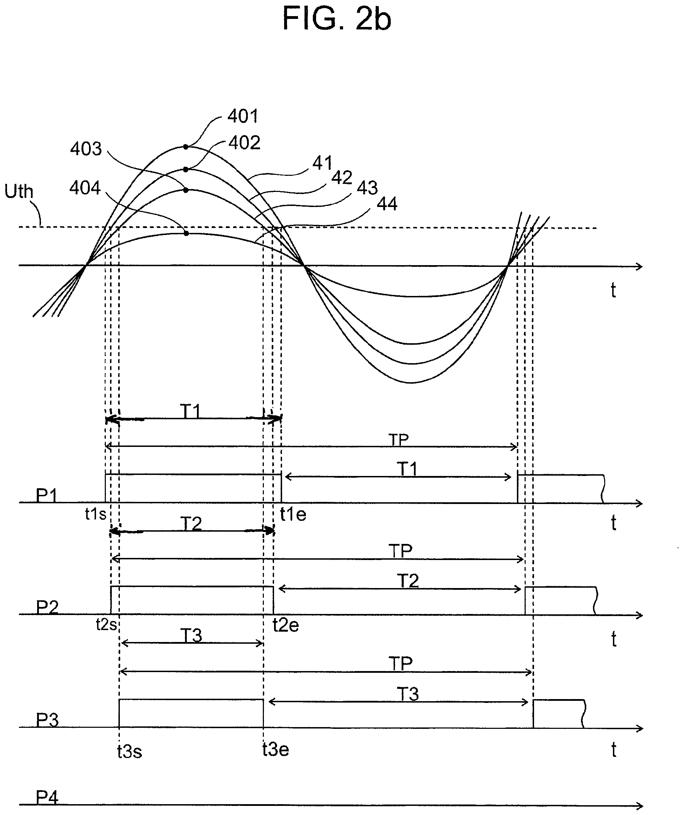

The pulsating DC emanating from rectifier 11 has timing characteristics corresponding to the amplitude of the voltage U_{AC}(t) of power source 4. This will be explained with reference to Fig. 2b. Thus, a pulse can be generated that has impulses that carry the AC amplitude information.

Fig. 2b shows an embodiment where a threshold Uth above zero is used for coding. It shows sinusoidal waveforms U1 to U4 in comparison with said threshold Uth. The sinusoidal waveforms are shown along time t at the abscissa. The waveforms can generally be addressed as Ui and can mathematically be described as Ui(t) = Ui0 * sin(2πft). Ui0 is the respective voltage amplitude, shown as U01, U02, U03 and U04 in Fig. 2b.

The top diagram shows that the various waveforms U1, U2, U3 and U4 cross the threshold voltage Uth at different points of time, depending on their amplitude. As explained earlier, the higher the AC amplitude Ui0 is, the earlier the instantaneous AC value of U1, U2, U3 and U4 surpasses the threshold and the later it drops back below it. Thus, the duration that the waveforms are above the threshold is an indirect measure for the voltage amplitude Ui0. Corresponding inversely, also the duration that the waveforms are below the threshold is an indirect measure for the respective voltage amplitude Ui0.

The higher the amplitude is, the longer is the waveform above the threshold, and if a simple comparison is made, the longer is a pulse indicating that the waveform is above the threshold. This is depicted for the waveforms U1, U2, U3 and U4 by pulses P1, P2, P3 and P4. Pulse P1 has impulses of duration T1 between start at t1s and end at t1e. Pulse P2 has impulses of duration T2 between start at t2s and end at t2e shorter than duration T1 because waveform U2 exceeds threshold Uth later and drops below it earlier than waveform U1. Pulse P3 has impulses of duration T3 between start at t3s and end at t3e shorter than T2 for substantially the same reasons as explained amongst T1 and T2. The diagrams show further that a hypothetical pulse P4 does not exist because the amplitude U04 of waveform U4 is so low that it never exceeds the threshold Uth.

It is further pointed out that the period duration of the sine wave can be determined, in the shown embodiment, from rising edge to rising edge as Tp in all pulses. It is further pointed out that Fig. 2b shows the relationships without a rectifier. And it is finally pointed out that the pulse durations T1, T2 and T3 carry indirectly the information on the respective voltage amplitude just as the off-times T1', T2' and T3' carry them as they remain when the on-time T1, T2, T3 is subtracted from the period time TP.

Thus, essentially, the invention produces a pulse with impulses where both the impulses or the breaks between impulses have encoded indirect information on the voltage AC amplitude from which these pulses were generated.

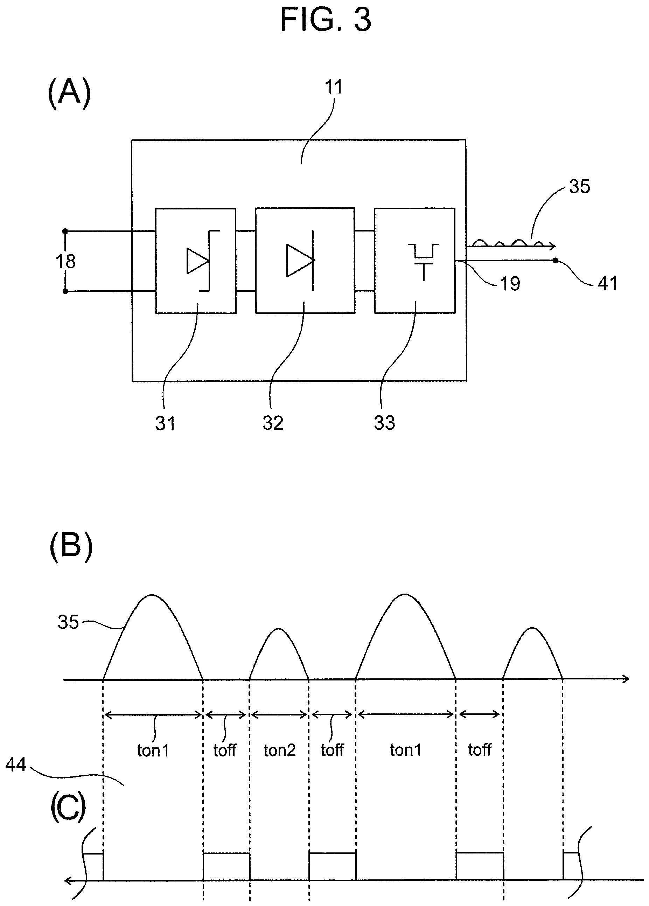

Fig. 3a shows a block diagram of the rectifying circuit 11. It may be a diode rectifier for half wave rectification or full wave rectification. Both circuits are well-known so that they are not fully described here. 18 are the input terminals of the coding circuit and thus receive U_{AC}(t) as input AC voltage having the amplitude to be coded and communicated. 31 is a first threshold voltage rendering circuit element on the AC side of the rectifying circuit 32 which provides a desired forward threshold. It may be asymmetric in a sense that it behaves differently in the two polarities of the AC passing it. For example, it may have a relatively low threshold voltage for the one polarity, such as a value between 0.5 and 1 volts, and may have a relatively high threshold voltage in the other polarity, such as 10 or 15 or 20 or 25 volts. The circuit element may be a Zener diode. If one of them does not provide the desired threshold, two or more of them may be series connected so that the respective thresholds add up. And likewise, depending on circumstances, element 31 may be omitted.

On the output side of the rectifying circuit 32 a second threshold rendering circuit element 33 may be provided. Accordingly, it sits on the pulsating DC side and will act on the pulses from both half waves in the same manner. It may be a dedicated circuit element, such as again a Zener diode, or it may be a circuit element of another circuit provided anyway, such as a transistor of a current limiter. A current limiter may comprise a current regulating transistor. This transistor may have a voltage threshold in forward direction, for example of a value between 2 and 7 volts.

When both the first threshold rendering circuit element 31 on the rectifying circuit input side and the second threshold voltage rendering circuit element 33 on the rectifying circuit output side are provided, and element 31 is asymmetric as explained, the output voltage at terminal 19 may be as shown with waveform 35 in Fig. 3b. It is again a pulsating DC with alternatingly higher and lower pulses. The pulses of lower amplitude come from the half wave that sees the higher threshold voltages, and vice versa. It is to be noted here that while the durations of the alternating two different voltage peaks are alternatingly different ton1 and ton2, the pause times or off-times toff between them are all the same and correlate in unique manner to the voltage amplitude of the AC from which they were generated. The correlation, however, is nonlinear.

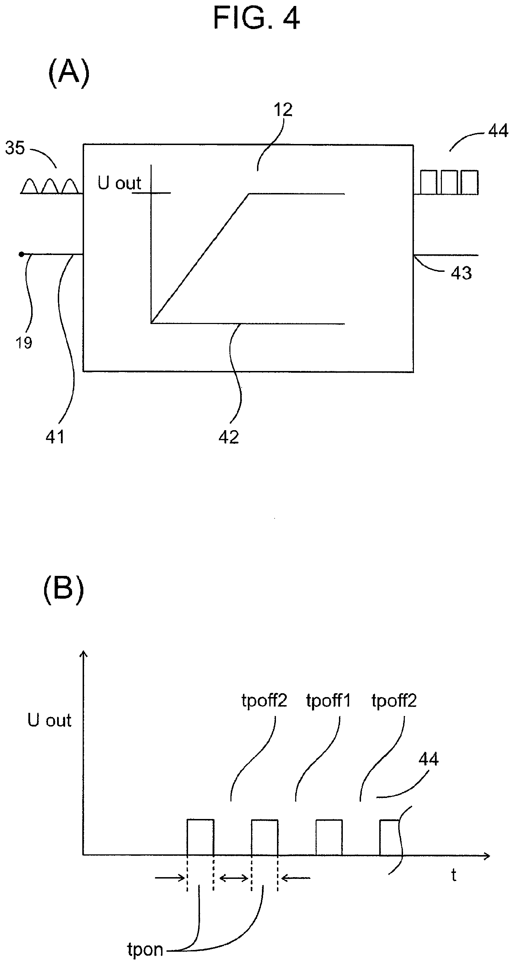

Fig. 4 shows a signaling means that finally generates pulses ready for being used. It is to be understood that the rectifying circuit itself may output pulsating DC voltage in a wider voltage range from as low as some few volts to up to 230 volts effectively. These values have to be brought to a common output level for allowing a common further processing. It may be made by a current limiter 42 with an input 41 and an output 43 that is a part of the signaling means. It is insofar pointed out that current limiter and voltage limiter is in this context the same as each of them would be provided to drive a defined subsequent circuit with a rated input current corresponding to a rated input voltage.

The current limiter 42 may be seen as a nonlinear element passing through, or even amplifying, low current values, but capping or limiting higher values. For example, the value U_{OUT} shown in Fig. 4 could be a voltage value suitable for digital signal processing of some few volts, for example between 1 and 6 volts. It may be designed for driving gates and digital circuitry, and/or it may be designed for driving an opto-coupler.

Further, current limiter circuit 42 may have a triggering characteristics, i.e. switching only between two values. At the output 43 of the current limiter 12, 42, a well-defined pulse sequence may appear. The lower half of Fig. 4 shows such a pulse. It is assumed that it is generated from the pulsating DC shown in Fig. 3b such that high impulses are generated for the pause times in the pulsating DC of Fig. 3b. It corresponds to the pulse shown in Fig. 3c. Then, the impulses have same impulse duration tpon corresponding to toff in figure 3b, but have alternatingly different time gaps tpoff1 and tpoff2 between them, respectively corresponding to the different lengths ton1 and ton2 of the halfwaves exceeding the thresholds. Output 43 of current limiter 42 may provide a waveform 44 as shown in figures 3c, and 4a, 4b.

Although Figs. 3 and 4 show distinct block diagrams, it is pointed out that the described functions may be implemented in an integrated manner in that single circuit elements may serve plural purposes. The diodes in a diode rectifier render a forward threshold voltage. And the transistor in a current limiter may provide the limiting effect shown with reference to Fig. 4, but may also provide a forward threshold voltage as addressed in Fig. 3.

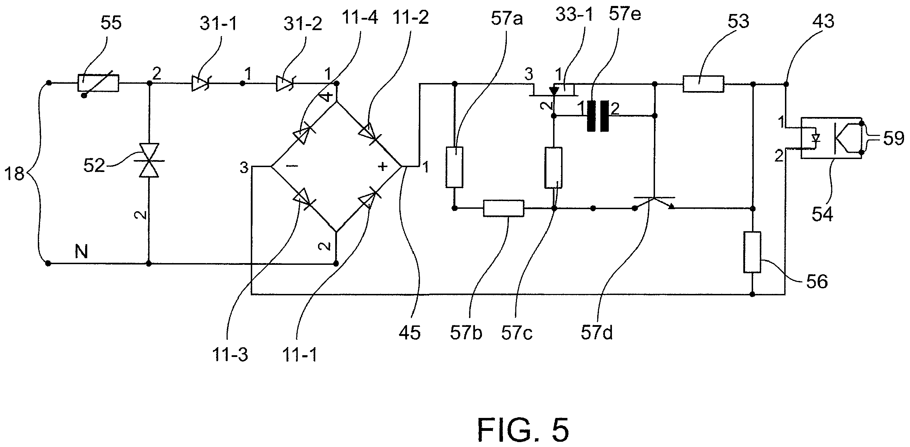

Fig. 5 shows a circuit diagram that may be a potential real circuit. It has a diode bridge full wave rectifier with four diodes 11-1 to 11-4 connected in the known manner. The two anode-cathode connections form the two AC inputs of the AC to be coded. The one cathode-cathode connection forms plus of the pulsating DC, and the one anode-anode connection forms minus. On the AC input side, a series connection of two Zener diodes 31-1 and 31-2 is assumed each, for example, having a reverse breakthrough voltage of a value between 20 and 25 volts, such as 22 volts. Further, a voltage spike protection element 52 may be provided between the AC terminals for shortcutting in bidirectional manner excess voltage spikes exceeding a rated value such as 250 volts in every half wave. Besides, a resistor 55 may be series connected for limiting current in case of certain device malfunctions.

On the output side of the rectifier circuit 11 appears a voltage U5 fed into a circuit serving as signaling means 12 and having both functions of current and voltage limitation as far as needed and threshold voltage provision. 33-1 is a current controlling transistor that limits the current and correspondingly voltage to certain quantities. The circuitry around it is for providing feedback control for driving said transistor 33-1. Said transistor 33-1 also has a certain forward threshold voltage of, for example, 4 or 5 volts. A series resistor 53 renders voltage division together with further resistor 56. In the embodiment of Fig. 5, the voltage division is chosen to provide an output level along transistor 56 suitable for driving an opto-coupler 54 as a possible means for galvanic isolation. It may be provided separately or integrated into coding circuit 10 or consumer 2. The opto-coupler has at its output a transistor switching between a high-ohmic and a low-ohmic state. Circuit elements 57a, 57b, 57c, 57d and 57e serve to render an appropriate driving of transistor 33-1. Terminals 59 are the output of the coding circuit 10.

The overall threshold voltage is thus the sum of individual contributions. The Zener diodes 31-1 and 31-2 both have forward threshold voltages similar to those of the diodes of the diode rectifier 11, altogether perhaps 3 volts for the one half wave. Transistor 33-1 may have a forward threshold of 5 or 6 volts and thus, together with the diodes, 8 or 9 volts in the one half wave. For the other half wave, the diode rectifier 11 exhibits the same properties just as the circuit elements on the DC side. But the Zener diodes in backward direction exhibit a much higher threshold, for example 22 volts instead of less than 1 volt in forward direction. Thus, the overall threshold voltage in the other half wave may be a value around 51 volts or so. But as said earlier, these values can be adjusted by appropriately selecting the various circuit elements.

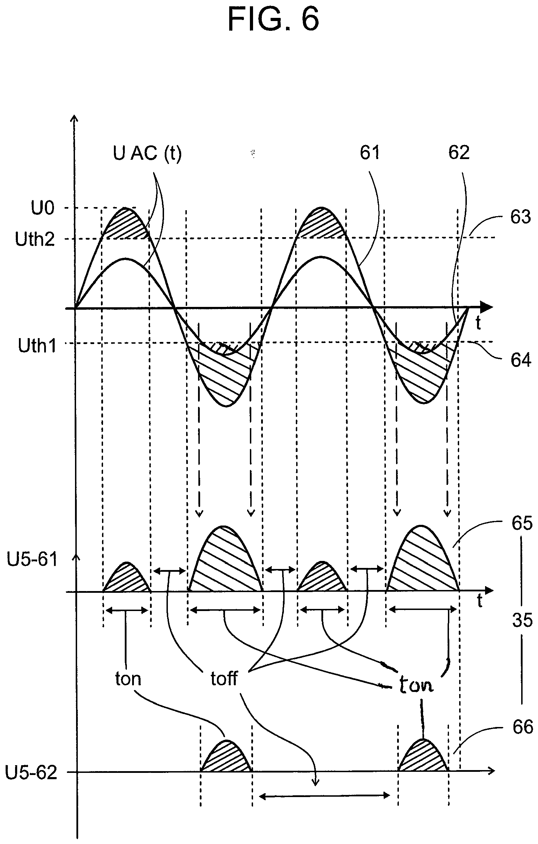

Fig. 6 shows waveforms for the circuit of figure 5. The AC is U_{AC}(t), threshold voltages are Uth1 and Uth2, and pulsating DC is U5-61 and U5-62 for two different amplitudes. The signals are shown along a common time scale. The difference to Fig. 2b is that in Fig. 6 forward threshold voltages are considered and examination is made on zero voltage level, not on a voltage level somewhere above zero as Uth in Fig. 2b. It is assumed in Fig. 6 that two different threshold voltages Uth1 and Uth2 are implemented in the circuit. It may be a combination of symmetric threshold rendering elements on the DC side and an asymmetric or plural asymmetric elements on the AC side as explained earlier. These thresholds are shown as levers 63 and 64 in Fig. 6.

Fig. 6 further shows two AC waveforms U_{AC}(t) with different amplitude and same frequency. Waveform 61 has a higher amplitude reaching higher than both thresholds, particularly higher than the higher Uth2 of the two thresholds. Waveform 62 has a lower amplitude reaching only across the lower Uth1 of the two thresholds, but not beyond the higher threshold Uth2. Waveform 61 with the higher amplitude renders the pulsating DC U5-61 shown as waveform 65. It has the already explained alternatingly different impulses of mutually different durations, but with off-times toff between them that all have the same duration, as also shown in figure 3b.

When amplitude is lower as in waveform 62, the one of the two half waves will be blocked by the higher threshold voltage Uth2 in the one direction completely, so that one set of half waves will be blocked in the one direction completely, so that one set of half waves in the waveform of numeral 65 disappears completely and only the other remains, shown as waveform 66 at the bottom of Fig. 6. The effect is that the frequency of impulses is only half of that of waveform 65. Besides, the off-time jumps to a higher value as amplitude drops as the one intersecting impulse disappears.

The advantage of having forward thresholds as explained is that evaluations can be made on zero level and thus can be made symmetrically for both half waves.

Particularly, off-times of the pulsating DC can be evaluated, where "off-time" means a voltage of 0 volts or, as explained earlier, a very low voltage of less than 2 or 1 volts.

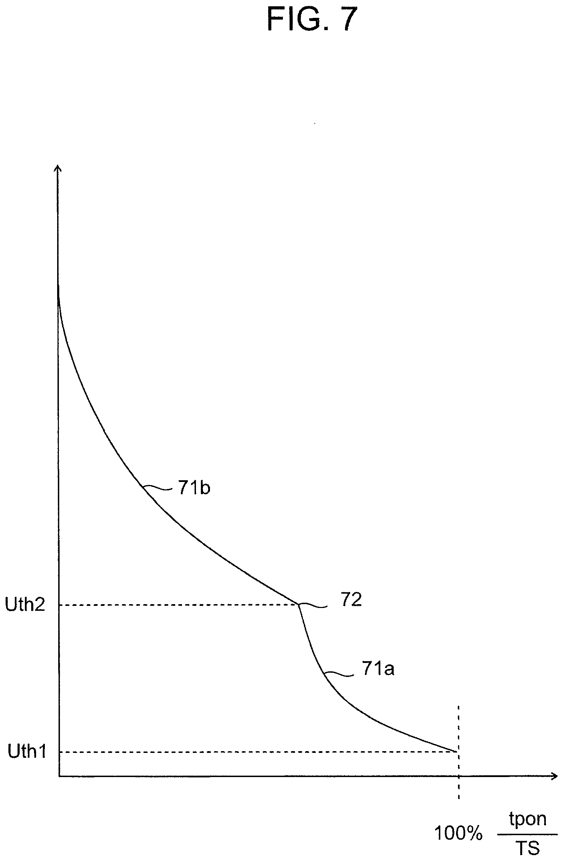

The advantage of having two different thresholds is that two distinct ranges of sensitivity are generated. This is shown with reference to Fig. 7 which shows the non-linear decoding characteristics of voltage amplitude over impulse duration. In figure 7, the abscissa corresponds to a relative on-time of the impulses output of the coding circuit, as for example shown in figure 3c over an entire AC period. It is assumed that the pulses are on while the pulsating DC is 0. In the characteristics of Fig. 7, the characteristics portion 71a on the right side of bent 72 is generated from relatively small voltage amplitudes reaching only above the lower of the two thresholds Uth1, whereas the characteristics portion 71b left of bent 72 is generated by AC with an amplitude exceeding both thresholds.

It is pointed out that an on-time ton of 100 percent of the pulsating DC cannot be reached with AC because the considered forward thresholds will also for high amplitude values cause off-times around zero crossings of the instantaneous values of the waveforms.

As already said earlier, the characteristics 71 of Fig. 7 is nonlinear. But it is well defined and can be computed from the characteristics of the used circuit elements. It is known beforehand and thus can be considered at the decoding side for determining the voltage amplitude from the measurable on-time.

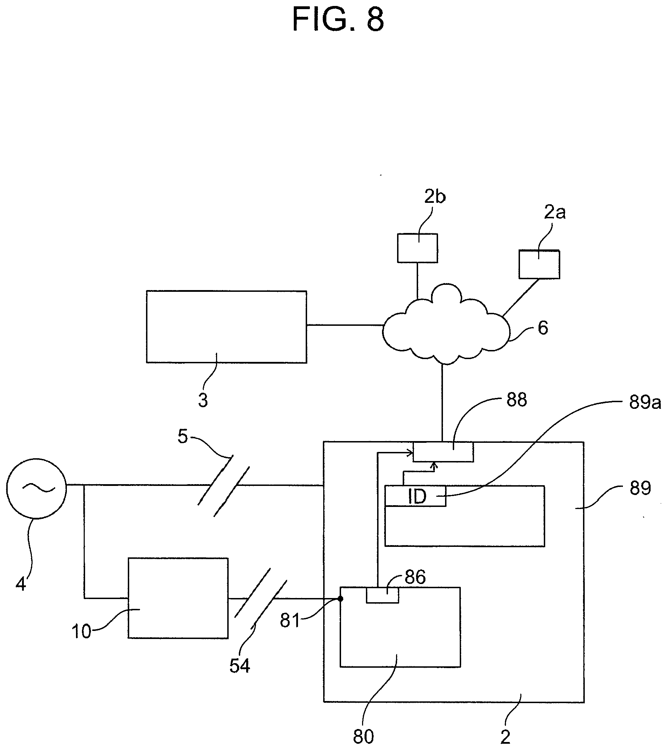

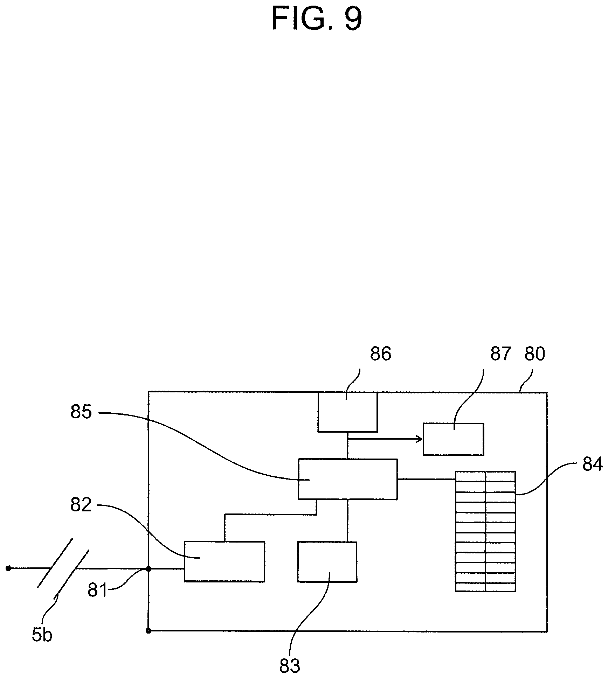

Figs. 8 and 9 show features on the decoding side. Fig. 8 is a diagram similar to Fig. 1, with, however, some more details regarding the consumer 2. It is assumed to have a main function 89 which may, for example, be a 48 volts AC electric motor for a window shade. The consumer 2 is assumed to have some kind of interface 88 towards controller 3 of the environment within which it operates as explained initially in this specification. It may be a KNX or EIB or IP interface. Further, here, the consumer 2 is assumed to have a decoding circuit 80 that receives a pulse signal as described so far. It is further assumed here that consumer 2 is galvanically insulated against source 4 by a transformer 5a for the power and is further isolated by an opto-coupler 5b for signaling, also regarding the impulses for voltage amplitude communication.

The consumer 2 may have an inscribed ID that uniquely identifies it in the environment managed by managing device 3. The ID is symbolized by box 89a in Fig. 8.

Referring to figure 9, the decoding circuit 80 is assumed to have a time measurement means 82 for measuring pulse durations. It may be configured in a variety of manners. It may be configured for measuring two subsequent pulses or for measuring only one of them. If relative values compared to a time reference such as the the AC period or AC half wave period are desired, the AC period must be provided in the one or other way. This is symbolized by time period information means 83. The time period information may be a firmly inscribed value corresponding to 50 Hz or 60 Hz. It may be a simple storage holding, for example, for 50 Hz environments a value of 20 msec for the full wave duration or a corresponding count value according to the calibration used in the system. For 60 Hz systems, it would hold a value of 16,67 msec. or a corresponding count value. However, the system may also be more sophisticated and may have a detection mechanism for detecting the desired time base. The detection mechanism may measure timing between corresponding edges of corresponding impulses, for example the rising edge or the falling edge of every other (every second) impulse. The time between them is influenced by whether no or one or two of the thresholds are exceeded by the AC signal. When no threshold is exceeded, no impulses are generated and a default value may be taken, or the frequency may be set to 0 Hz, indicating DC or 0 input according to a chosen convention. When said edges are detected, it indicates AC. The measured timings when only one threshold is exceeded are twice those when both thresholds are exceeded. For finally finding the right value, the time period information means 83 may compare the measured timings with expected values (20 or 40 msec in 50 Hz systems, 16, 67 or 33.3 mssec in 60 Hz systems), and it may then decided the time basis/frequency be in accordance with the result of said comparison, for example as 50 Hz, 60Hz, other frequency.

If a certain amount of inaccuracy is accepted, an average can be set in or by time period information means 83 as time basis, such as 18,33 msec or a corresponding count value as the average of 20 msec and 16,66 msec.

Insofar, and also generally speaking, processing hardware with some processing capabilities may be provided in consumer device 2. It may be a microcontroller or a microprocessor including one or more of components like a CPU, a RAM, a ROM, registers, A/D- and D/A interfaces, communication interface, a bus and the like. The processing hardware may take over some or all of the various tasks mentioned above and also in the following and may thus constitute one or more means for implementing those tasks.

If one or both threshold is/are exceeded only once initially and remains like this for a defined duration exceeding a full wave by applied DC, a qualitative decision on DC in certain ranges can be taken without deciding on its precise level. If no threshold is ever exceeded, it can be decided as no signal/voltage.

Decoding means 85 finally obtains the voltage amplitude value by receiving from means 82 the pulse duration, if needed from means 83 the time bases for forming the relative value and capable of accessing a table 84. The table 84 actually holds a characteristics corresponding to that of Fig. 7 with absolute or relative time values as input, and corresponding voltage amplitudes as output. Decoder 9 thus obtains a voltage amplitude value and outputs it through an appropriate interface 86. Likewise, it may internally be stored in some kind of storage 87.

It is assumed here that decoding as described with reference to Fig. 9 is made on the digital side. It may be own hardware or it may be implemented as a task running in time sharing manner on some kind of digital structure. A time measurement in device 82 may be made by counting.

Reverting back to Fig. 8, decoding circuit 80 finally outputs a voltage amplitude value representing the voltage amplitude of AC power source 4. The consumer device 2 may then be configured to output it towards controller 3. It may be output together with an identification information 89a so that a controller 3 can determine from which of the connected consumer devices 2, 2a, 2b the information comes. Interface 88 may have a related information assembling and communication management function.

But as also said earlier, decoding circuit 80 may be provided separately from a particular consumer 2 or may be provided directly in management device 3.

The coding circuit 10 may be configured to operate continuously or periodically or upon external triggering. The decoding circuit 80 may be configured to operate continuously or upon some kind of triggering.

A coding circuit for coding an AC voltage amplitude without using a rectifying circuit may have signalling means for generating and outputting a signal representing a timing value of an AC voltage at the circuits input, the timing value preferably being the absolute or relative time for which the periodic waveform remains above or below a certain threshold that is not zero. Reference is insofar made to Figure 2b.

The detections and evaluations described above may be executed continuously or periodically or event-triggered. The coding circuit may operate continuously or periodically, such as once or twice or a defined plurality of times per unit time which may be in the range of seconds or minutes, or may operate once when powered-up, or may have a trigger input for receiving an external trigger signal. A signal from the coding circuit 10 may be used as trigger/wakeup signal on the side of the consumer 2 for the related measures there.

Features described in this specification and/or in the claims and/or shown in a figure shall be deemed combinable with and amongst each other also if their combination is not expressly described, to the extent that the combination is technically feasible. Features described in a certain context, embodiment, figure or claim shall be deemed separable from this claim, context, embodiment or figure and shall be deemed combinable with every other figure, claim, context or embodiment, to the extent that it is technically feasible. Embodiments and figures shall not be understood as being meant necessarily exclusive against each other. Descriptions of a method or procedure or a method step or a procedural step shall be understood also as description of means for implementing the method or procedure or method step or procedural step and/or possibly also as a data carrier holding program instructions of executable code adapted for implementing the method or procedure or method step or procedural step, and vice versa.

### List of reference numerals

- 1: managed environment
- 2, 2a, 2b: consumers
- 3: management apparatus
- 4: power source
- 5: transformer
- 6: network connection
- 10: coding circuit
- 11: rectifying circuit
- 11-1, 11-2, 11-3, 11-4: diodes
- 12: signaling circuit
- 18: input terminals
- 19: output terminal
- 31: threshold rendering means
- 31-1, 31-2: Zener diodes
- 32: diode rectifier
- 33: threshold rendering means
- 33-1: current controlling transistor
- 35: pulsating DC
- 41: input
- 42: current limitation
- 43: output
- 52: voltage spike protection element
- 53: resistor
- 54: opto-coupler
- 55, 56: resistor
- 57a to 57c: resistors
- 57e: capacitor
- 57d: transistor
- 59: output terminal
- 61, 62: AC waveforms
- 63, 64: thresholds
- 65, 66: pulsating DC voltages
- 71, 71a, 71b: characteristics
- 72: bent point
- 80: decoding circuit
- 81: input
- 82: time measurement circuit
- 83: time bases provision circuit
- 84: table
- 85: AC voltage amplitude determination circuit
- 86: output circuit
- 87: storage
- 88: interface
- 89: consumer main function
- 89a: ID storage

## Claims

1. A coding circuit (10) for coding an AC voltage amplitude, comprising
a rectifying circuit (11) configured to output a pulsating DC voltage (U5), and
signalling means (12) for generating and outputting a signal representing a timing value of said pulsating DC voltage.

2. The circuit (10) of claim 1, wherein the rectifying circuit (11) has a diode rectifier (11a-d).

3. The circuit (10) of one of the preceding claims, wherein the rectifying circuit (11) has threshold rendering means (11a-d, 31, 33) for rendering a forward threshold voltage.

4. The circuit (10) of one of the preceding claims, wherein the rectifying circuit (11) has a full wave diode rectifier (11a-d) and the threshold rendering means (11a-d, 31, 33) is configured for rendering a first forward threshold voltage for the one half wave and for rendering a second forward threshold voltage for the other half wave.

5. The circuit (10) of claim 4, wherein the threshold rendering means (11a-d, 31, 33) is configured to render different first and second forward threshold voltages.

6. The circuit (10) of one of the preceding claims, wherein the threshold rendering means (11a-d, 31, 33) comprises an electrically asymmetric circuit element, particularly a Zener diode (31-1, 31-2) on the AC side of the rectifier (11).

7. The circuit (10) of one of the preceding claims, wherein the threshold rendering means (11a-d, 31, 33) comprise a transistor (33-1) on the DC side of the rectifier (11).

8. The circuit (10) of one of the preceding claims, wherein the signalling means (12) comprises a pulse generator configured to generate a pulse signal in accordance with said timing value of said pulsating DC voltage (U5).

9. The circuit (10) of claim 8 and one of the claims 3 to 5, wherein the pulse generator is configured to generate a pulse signal in accordance with the on-time (ton) and/or the off-time (toff) of the pulsating DC voltage.

10. The circuit (10) of claim 8 or 9, further comprising an opto-coupler (54) connected to receive said pulse signal at its input.

11. The circuit (10) of one of the claims 8 to 10, further comprising time measurement means for measuring the duration of one of said pulses and conversion means for converting the measured duration into an AC voltage amplitude according to a predefined characteristics.

12. The circuit (10) of claim 11, wherein the time measurement means comprises a counter for providing a count value in accordance with said pulse duration, and/or wherein said conversion means comprises a table storage for storing a table with pairs of a respective pulse duration as input and a respectively corresponding AC voltage amplitude as output.

13. The circuit (10) of claim 4 or 5, wherein the threshold rendering means is configured to render said first forward threshold voltage higher than 20 or 30 or 40 volts and possibly lower than 100 or 60 or 50 volts, and wherein the threshold rendering means is configured to render said second forward threshold voltage lower than 40 or 30 or 20 volts and possibly higher than 4 or 6 or 8 volts.

14. The circuit (10) of one of the preceding claims, comprising a current limiter (51) on the DC side of the rectifying circuit (11), the current limiter comprising a current controlling transistor (33-1) that may be a part of the threshold rendering means (11a-d, 31, 33).

15. A decoding circuit (10) for decoding a signal representing an AC voltage amplitude, comprising
an input for receiving a pulse signal representing an AC voltage amplitude and preferably generated by a coding circuit according to one of the preceding claims, and
a conversion means for generating an AC voltage amplitude information in accordance with the duration of an impulse of the received pulse signal according to a predefined characteristics, the conversion means preferably comprising a table with plural pairs of impulse durations and corresponding AC voltage amplitude, and
outputting means for outputting said AC voltage amplitude information.

16. A voltage information system comprising
a coding circuit (10) according to one of the claims 1 to 14, and
a decoding circuit according to claim 15.
